# FASCICULE DE BREVET EUROPEEN

(11) **EP 2 804 161 B1**
(45) Date de publication et mention de la délivrance du brevet: **12.07.2017**
(21) Numéro de dépôt: 14168493.6
(22) Date de dépôt: 15.05.2014
(51) Int. Cl.: G08B 13/14

(54) **Coffret comprenant un socle, un boîtier et un organe rotatif d'assemblage**
Kasten, der aus einem Sockel, einem Gehäuse und einem Drehorgan zum Zusammenbau besteht
Kit including a base, a housing and a rotary assembly member

(30) Priorité: 17.05.2013 FR 1354466
(43) Date de publication de la demande: 19.11.2014
(73) Titulaire: Hager Security, 38920 Crolles (FR)
(72) Inventeur: Dromard, Jean-Claude, 38530 CHAPAREILLAN (FR); Dumas, Didier, 38650 SAINT MICHEL LES PORTES (FR)
(74) Mandataire: Nuss, Laurent

(56) Documents cités:
- EP-A1- 2 503 526
- EP-A2- 1 045 354
- GB-A- 2 325 018
- GB-A- 2 463 462
- US-A- 5 751 218
- US-B1- 6 433 700

## Description

La présente invention concerne le domaine des coffrets comprenant des boîtiers pouvant être montés sur des socles, en particulier le domaine des coffrets formant des dispositifs électroniques d'alarme tels que ceux munis de détecteurs de danger en vue de là protection des personnes et des biens, que l'on installe dans les espaces domestiques, commerciaux ou industriels afin d'avertir les occupants ou à distance de l'existence d'un danger.

Dans les coffrets généralement utilisés, le socle est fixé contre la surface d'un mur ou d'un plafond et le boîtier qui contient la partie électronique est monté sur le socle grâce à des vis de fixation ou par des ergots d'accrochage réciproque.

Le brevet EP 2 503 526 décrit un boîtier dans lequel un caisson contenant une carte électronique et un socle comprennent des moyens de guidage en rotation et d'accrochage directement de l'un sur l'autre.

La présente invention a pour objet d'améliorer la manière d'accoupler des boîtiers et des socles.

Il est proposé un coffret qui comprend un boîtier et un socle pouvant être placés l'un au-dessus de l'autre et assemblés par l'intermédiaire d'un organe rotatif d'assemblage, dans lequel le boîtier est muni d'un commutateur électrique.

Il est proposé d'une part que le boîtier et l'organe rotatif d'assemblage soient munis de moyens de guidage en rotation et d'accrochage pour être montés l'un sur l'autre dans une position angulaire initiale de montage et être tournés l'un par rapport à l'autre vers une position angulaire intermédiaire indexée de montage où un plot de l'organe rotatif d'assemblage actionne ledit commutateur électrique; et d'autre part que le socle et l'organe rotatif d'assemblage soient munis de moyens de guidage en rotation et d'accrochage pour être montés l'un sur l'autre dans position angulaire intermédiaire indexée de montage et tournés l'un par rapport à l'autre
vers une position angulaire finale indexée d'assemblage où le plot de l'organe rotatif d'assemblage libère le commutateur électrique.

Le coffret peut comprendre des moyens de butée pour maintenir dans les deux sens le boîtier et l'organe rotatif d'assemblage à la position angulaire intermédiaire indexée de montage, le socle comprenant un moyen de libération pour libérer au moins partiellement les moyens de butée lorsqu'il est mis en place à ladite position angulaire intermédiaire indexée de montage et autoriser la rotation de l'organe rotatif d'assemblage jusqu'à la position angulaire finale indexée d'assemblage.

La position angulaire intermédiaire peut être située sur le chemin de l'organe rotatif d'assemblage entre la position angulaire initiale indexée de montage et la position angulaire intermédiaire indexée.

Le coffret peut comprendre des moyens de butée de l'organe rotatif d'assemblage par rapport au boîtier à la position angulaire initiale indexée de montage, dans le sens opposé à sa rotation vers la position angulaire intermédiaire indexée, des moyens de butée de l'organe rotatif d'assemblage par rapport au boîtier à la position angulaire intermédiaire indexée de montage dans les deux sens, les moyens de butée dans le sens de la rotation de l'organe rotatif d'assemblage depuis la position angulaire intermédiaire indexée vers la position angulaire finale étant escamotables sous l'effet d'un organe de libération du socle, et des moyens de butée de l'organe rotatif d'assemblage par rapport au boîtier à la position angulaire finale indexée, dans le sens de sa rotation vers la position angulaire initiale, ces moyens de butée étant escamotables.

Les moyens de butée peuvent comprendre des languettes et des nervures de butée aménagées respectivement sur le boîtier et l'organe rotatif d'assemblage.

Le boîtier et le socle peuvent être placés et maintenus l'un au-dessus de l'autre dans une position angulaire déterminée par des moyens de butée réciproques.

L'organe rotatif d'assemblage peut comprendre un plateau interposé entre le boîtier et le socle et une couronne périphérique.

Le boîtier peut être muni d'un commutateur électrique actionné lorsque l'organe rotatif d'assemblage est à la position angulaire finale.

Les moyens de guidage en rotation et d'accrochage peuvent comprendre des moyens d'appui axial, des moyens d'appui radial et des ergots d'accrochage.

Le boîtier peut contenir une carte électronique munie dudit commutateur électrique.

Un coffret comprenant un boîtier et un socle et muni d'un organe rotatif d'assemblage va maintenant être décrit à titre d'exemple non limitatif et illustré par le dessin sur lequel :
- la figure 1 représente une coupe d'un coffret assemblé ;
- la figure 2 représente une vue de l'arrière vers l'avant d'une embase du boîtier ;
- la figure 3 représente une vue de l'arrière vers l'avant de l'organe rotatif d'assemblage ;
- la figure 4 représente une vue de l'arrière vers l'avant du socle ;
- les figures 5 à 10 représentent à plat des coupes partielles médianes substantiellement cylindriques et, aux extrémités de ces coupes partielles, des coupes partielles radiales, approximativement selon A-A des figures 2, 3 et 4, montrant schématiquement des positions angulaires relatives indexées de montage et d'assemblage du coffret ;
- la figure 11 représente une coupe locale transversale selon XI-XI de la figure 7 ; et
- la figure 12 représente une coupe locale transversale selon XII-XII de la figure 9.

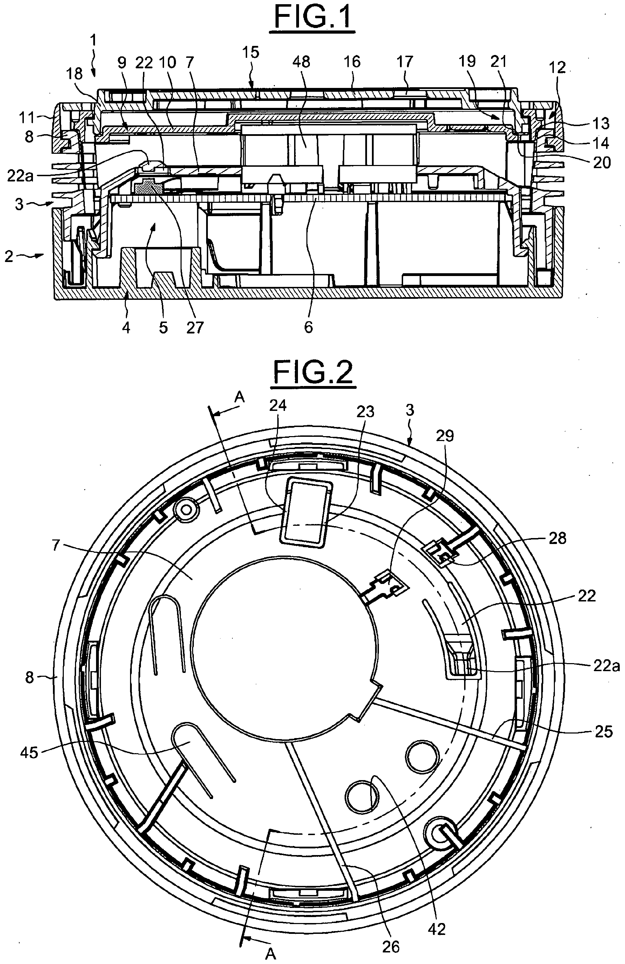

Comme illustré sur la figure 1, un coffret 1, par exemple en une matière plastique, comprend un boîtier cylindrique 2 composé d'une embase arrière 3 et d'un couvercle avant 4 qui peuvent être accouplés l'un au-dessus de l'autre par tous moyens d'accouplement appropriés (non représentés), par exemple par encliquetage, et qui, en position accouplée, délimitent entre eux une chambre 5.

Dans la chambre 5 est installée une carte électronique 6, maintenue en position par exemple par conjugaison de formes.

L'embase 3 comprend un fond 7 radial et une couronne périphérique 8, la carte électronique 6 étant disposée parallèlement au fond 7.

Le coffret 1 comprend également un organe rotatif d'assemblage 9 qui comprend un plateau radial 10 placé à proximité du fond 7 de l'embase 3 et qui comprend une couronne périphérique 11 destinée à être accouplée à la couronne périphérique 8 de l'embase 3 par l'intermédiaire de moyens de guidage en rotation et d'accrochage 12, ces moyens 12 comprenant des zones annulaires radiales d'appui réciproque axial 13 et des zones annulaires circonférentielles de centrage réciproque radial 14.

Le coffret 1 comprend en outre un socle arrière 15 qui comprend un plateau radial 16 qui est placé à proximité du plateau rotatif 9 et qui présente des trous traversants 17 pour le passage de vis de fixation (non représentées). Le socle arrière 15 comprend en outre une couronne périphérique 18 destinée à être accouplée à la couronne périphérique 11 de l'organe rotatif d'assemblage 9 par l'intermédiaire de moyens de guidage en rotation et d'accrochage 19, ces moyens 19 comprenant des zones annulaires radiales d'appui réciproque axial 20 et des zones annulaires circonférentielles de centrage réciproque radial 21.

Comme illustré en particulier sur la figure 2, le plateau 7 de l'embase 3 présente, sur une zone circonférentielle médiane, c'est-à-dire à distance de son centre et de sa périphérie, une languette 22 aménagée dans l'épaisseur du plateau 7 et séparée du reste de ce dernier par une fente approximativement en forme de U. Cette languette 22, déformable élastiquement, s'étend dans le sens des aiguilles d'une montre.

Le plateau 7 de l'embase 3 présente, sur ladite zone circonférentielle médiane, deux nervures rapprochées de butées 23 et 24 en saillie vers l'arrière, décalées dans le sens inverse des aiguilles d'une montre par rapport à la languette 22, une nervure de butée 25 en saillie vers l'arrière, décalée dans le sens des aiguilles d'une montre par rapport à la languette 22 et une nervure de butée 26 en saillie vers l'arrière et décalée dans le sens des aiguilles d'une montre par rapport à la languette 22, ces nervures 23, 24, 25 et 26 coupant transversalement ladite zone circonférentielle médiane.

Comme illustré sur les figures 1 et 2, la partie d'extrémité de la languette 22 présente un bossage arrière 22a, en saillie par rapport à la face arrière du plateau 7, et la carte électronique 6 est munie d'un commutateur 27 situé au-dessous de ce bossage arrière 22a.

Le plateau 7 de l'embase 3 présente, sur une zone circonférentielle médiane, deux plots arrière 28 et 29 en saillie vers l'arrière, espacés radicalement et en forme L opposés, situés entre et à distance de la languette 22 et des nervures de butées 23 et 24.

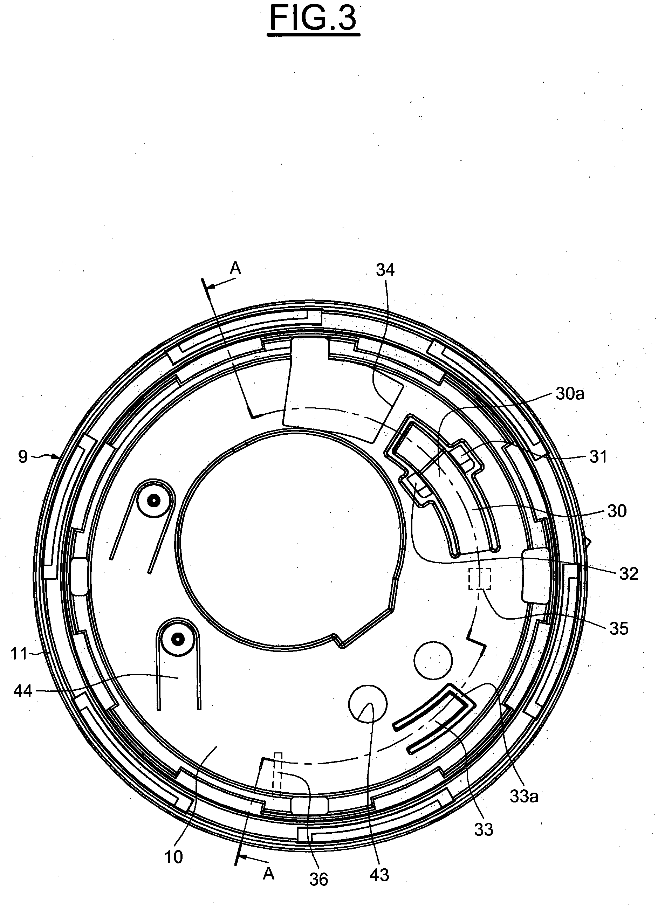

Comme illustré en particulier sur la figure 3, le plateau 10 de l'organe rotatif 9 présente, sur une zone circonférentielle médiane correspondant à celle précitée du plateau 7 de l'embase 3, une languette 30 aménagée dans l'épaisseur du plateau 10 et séparée du reste de ce dernier par une fente approximativement en forme de U. Cette languette 30, déformable élastiquement, s'étend dans le sens contraire des aiguilles d'une montre et sa partie d'extrémité présente une bosse arrière 30a, en saillie par rapport à la face arrière du plateau 7.

La languette 30 est munie de deux ailes latérales 31 et 32 en saillie vers l'avant et en forme L opposées.

Le plateau 10 de l'organe rotatif 9 présente, sur ladite zone circonférentielle médiane et décalée dans le sens des aiguilles d'une montre par rapport à la languette 30, une languette 33 aménagée dans l'épaisseur du plateau 10 et séparée du reste de ce dernier par une fente approximativement en forme de U. Cette languette 33, déformable élastiquement, s'étend dans le sens contraire des aiguilles d'une montre et son extrémité 33a s'étend en saillie vers l'avant par rapport à la face avant du plateau 10.

Le plateau 10 de l'organe rotatif 9 présente, sur ladite zone circonférentielle médiane et décalée dans le sens contraire des aiguilles d'une montre par rapport à la languette 30, une ouverture traversante 34.

Le plateau 10 de l'organe rotatif 9 présente, sur ladite zone circonférentielle médiane et décalée dans le sens des aiguilles d'une montre par rapport à la languette 30 et à proximité de cette dernière, un plot 35 en saillie vers l'avant.

Le plateau 10 de l'organe rotatif 9 présente en outre, sur ladite zone circonférentielle médiane et décalée dans le sens des aiguilles d'une montre par rapport à la languette 33, une nervure 36 en saillie vers l'avant.

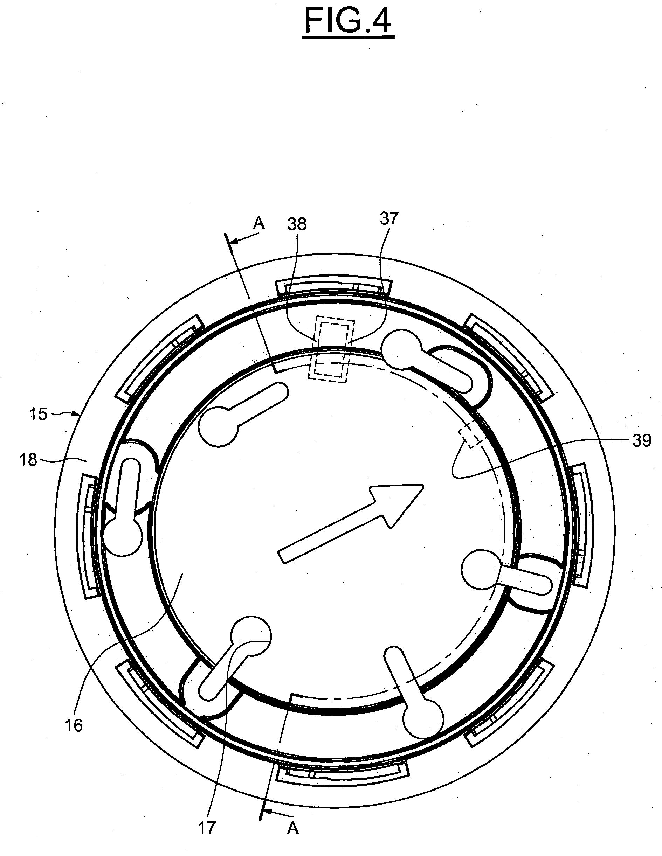

Comme illustré sur la figure 4, le plateau 16 du socle 15 comprend, sur ladite zone circonférentielle médiane, deux nervures rapprochées 37 et 38 en saillie vers l'avant et un plot de libération 39 en saillie vers l'avant, décalé angulairement dans le sens des aiguilles d'une montre par rapport aux nervures 37 et 38.

Selon un exemple particulier de réalisation, les dispositions angulaires suivantes, par rapport à l'axe du coffret 1 et regardées de l'arrière vers l'avant, peuvent être adoptées.

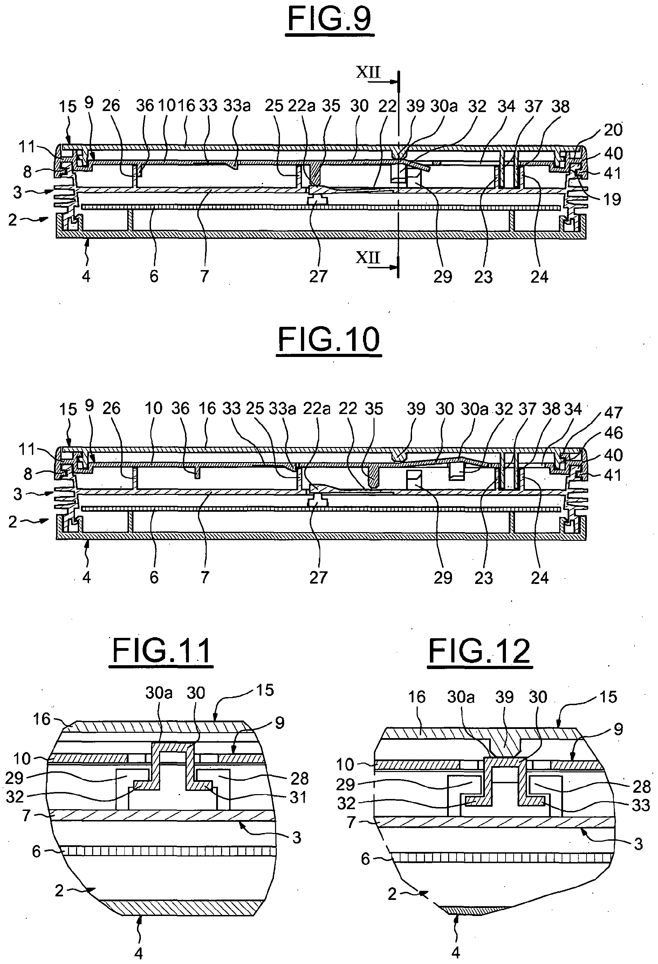

En considérant, à titre de référence angulaire, la position du bossage 22a et du plot 35, en appui l'un sur l'autre dans ladite position angulaire intermédiaire (figure 9), des positions angulaires suivantes peuvent être adoptées à titre d'exemples de réalisation.

La position angulaire de l'extrémité 33a de la languette 33 peut être décalée d'environ 35° dans le sens des aiguilles d'une montre.

La position angulaire de la nervure de butée 25 peut être décalée d'environ 15° dans le sens des aiguilles d'une montre.

La position angulaire des plots 28 et 29 et des ailes 31 et 32 de la languette 30 peut être décalée d'environ 30° dans le sens contraire des aiguilles d'une montre,

La position angulaire des nervures de butée 23 et 24 et des nervures de butée 37 et 38 peut être décalée d'environ 70° dans le sens contraire des aiguilles d'une montre.

La position angulaire de la nervure de butée 26 et de la nervure de butée 36 peut être décalée d'environ 65° dans le sens des aiguilles d'une montre, et la position angulaire de la bosse 30a de la languette 30 et du plot 39 peut être décalée d'environ 30° dans le sens contraire des aiguilles d'une montre.

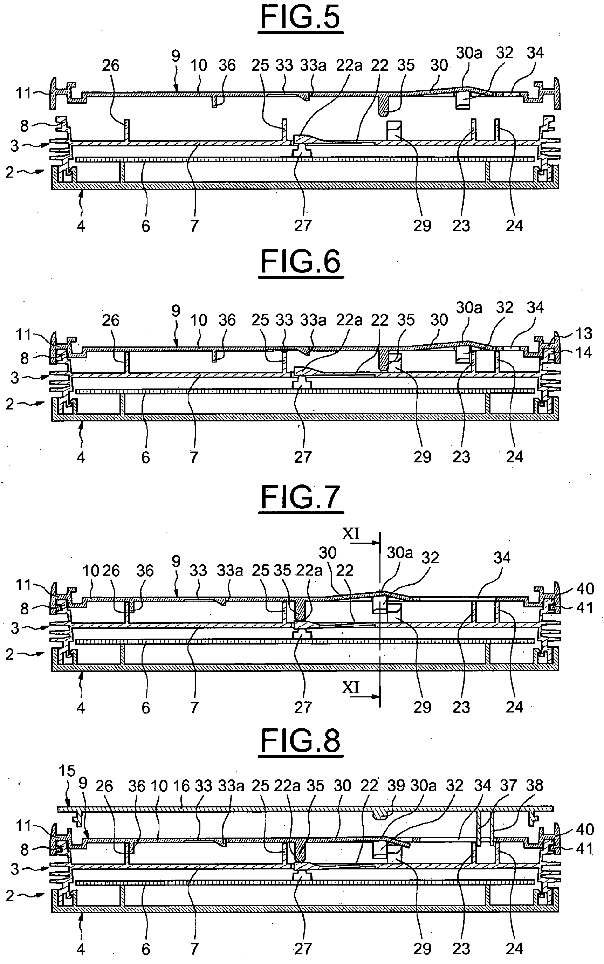

En se reportant aux figures 5 à 10, on va maintenant décrire comment le coffret peut être assemblé et comment il fonctionne, en considérant que le coffret 1 est observé de l'arrière vers l'avant lorsqu'il est question d'une rotation de l'organe rotatif d'assemblage 9 dans le sens des aiguilles d'une montre ou dans le sens contraire.

En référence aux figures 5 à 7, on va tout d'abord décrire le montage de l'organe rotatif d'assemblage 9 sur le boîtier 2.

Comme illustré sur la figure 5, on place l'organe rotatif d'assemblage 9 axialement et en face de l'embase 3, dans une position angulaire telle que les ailes en saillie 31 et 32 de la languette 30 soient à proximité de la nervure de butée 23 dans le sens des aiguilles d'une montre. Les ailes en saillie 31 et 32 et la nervure de butée 23 forment des butées dans le sens contraire des aiguilles d'une montre.

Puis, comme illustré sur la figure 6, on place l'un sur l'autre l'organe rotatif d'assemblage 9 et l'embase 3, jusqu'à mettre en appui les zones annulaires radiales d'appui réciproque axial 13 et les zones annulaires circonférentielles de centrage réciproque radial 14 des moyens de guidage en rotation et d'accrochage 12. L'organe rotatif d'assemblage 9 et l'embase 3 sont alors, l'un par rapport à l'autre, dans une position angulaire initiale de montage.

Ensuite, comme illustré sur la figure 7, on fait tourner ou pivoter, selon l'axe du coffret 1, l'organe rotatif d'assemblage 9 par rapport à l'embase 3 dans le sens des aiguilles d'une montre jusqu'à ce que le plot de butée 36 vienne en butée contre la nervure de butée 26. Après cette première rotation, l'organe rotatif d'assemblage 9 et l'embase 3 sont alors, l'un par rapport à l'autre, dans une position intermédiaire de montage.

Les moyens de guidage en rotation et d'accrochage 12 comprennent en outre des pluralités d'ergots allongés annulaires d'accrochage 40 et 41 qui sont aménagés respectivement sur les couronnes 8 et 11 de l'embase 3 et de l'organe rotatif d'assemblage 9 et qui assurent le montage et le maintien entre eux de l'embase 3 et de l'organe rotatif d'assemblage 9. Les ergots allongés annulaires d'accrochage 40, qui sont espacés circonférentiellement, et les ergots allongés annulaires d'accrochage 41, qui sont également espacés circonférentiellement, peuvent être agencés pour indexer l'organe rotatif d'assemblage 9 par rapport à l'embase 3 lorsqu'ils sont mis l'un sur l'autre.

Lors de ladite première rotation, les branches des ailes 31 et 32 de la languette 30, qui sont parallèles aux plateaux 7 et 10, rencontrent et franchissent les plots en saillies 28 et 29 en déformant élastiquement la languette 30 vers l'avant et la partie avant 33a de la languette 33 rencontre et franchit la nervure de butée 25 en déformant la languette 33 vers l'arrière. Des chanfreins inclinés peuvent être aménagés pour faciliter ces franchissements.

Dans la position angulaire intermédiaire de montage, l'organe rotatif d'assemblage 9 est immobilisé en rotation par le fait que la nervure de butée 36 de l'organe rotatif d'assemblage 9 est à faible distance de la nervure de butée 26 de l'embase 3 dans le sens des aiguilles d'une montre et que les ailes 31 et 32 de la languette 30 de l'organe rotatif d'assemblage 9 sont à faible distance des plots 28 et 29 de l'embase 3 dans le sens contraire des aiguilles d'une montre. La figure 11 montre que les branches des ailes 31 et 32 et des plots de butées 28 et 29, parallèles aux plateaux 7 et 10, sont en face les unes des autres et forment des butées.

De plus, dans ladite position angulaire intermédiaire de montage, le plot 35 de l'organe rotatif d'assemblage 9 s'est placé sur le bossage 22a de la languette 22 de l'embase 3 et cette dernière s'est pliée vers l'avant et sollicite le commutateur 27 de la carte électronique 6.

A cette position angulaire de sollicitation du commutateur 27 peuvent correspondre des possibilités de coupure de l'alimentation électrique ou de programmation ou de paramétrage de la carte électronique 6 ou d'autoprotection.

Comme illustré sur les figures 2 et 3, des actions de programmation ou de paramétrage peuvent être réalisées par exemple grâce à un outil pouvant être engagé au travers de trous en coïncidence 42 et 43 des plateaux 7 et 10 de l'embase 3 et de l'organe rotatif d'assemblage 9 pour agir sur des commutateurs de la carte électronique 6 ou en appuyant sur des languettes complémentaires 44 du plateau 10 de l'organe rotatif d'assemblage 9, aménagées dans son épaisseur et déformable élastiquement, pour agir sur des commutateurs de la carte électronique 6 par l'intermédiaire de languettes en coïncidence 45 du plateau 7 de l'embase 3, aménagées dans son épaisseur et déformables élastiquement, avec interposition de plots en saillie.

En référence aux figures 8 à 10, on va tout d'abord décrire le montage du socle 15 sur le boîtier 2 par l'intermédiaire de l'organe rotatif d'assemblage 9.

Comme illustré sur la figure 8, on place le socle 15 axialement et en face de l'embase 3, dans une position angulaire telle que les nervures rapprochées 37 et 38 soient adjacentes à et entre les nervures rapprochées 23 et 24.

Puis, comme illustré sur la figure 9, on place l'un sur l'autre le socle 15 et l'organe rotatif d'assemblage 9, jusqu'à mettre en appui les zones annulaires radiales d'appui réciproque axial 20 et les zones annulaires circonférentielles de centrage réciproque radial 21 des moyens de guidage en rotation et d'accrochage 19, en faisant passer les nervures 37 et 38 au travers de l'ouverture 34 de l'organe rotatif d'assemblage 9. L'organe rotatif d'assemblage 9 et le socle 15 sont alors, l'un par rapport à l'autre, dans ladite position angulaire intermédiaire de montage et sont solidaires ou immobilisés en rotation l'un par rapport à l'autre par le fait que les nervures rapprochées 37 et 38 sont entre les nervures rapprochées 23 et 24.

Lors de cette mise en place, le plot 39 du socle 15 vient agir sur la bosse 30a de la languette 30 de l'embase 3 et la repousse vers l'avant, de telle sorte que les ailes 31 et 32 de cette languette 30 sont libérées par rapport aux plots de butée 28 et 29 de l'embase 3. La figure 12 montre que les branches des ailes 31 et 32 et des plots de butées 28 et 29, parallèles aux plateaux 7 et 10, ne sont plus en face les unes des autres et sont escamotées.

Ensuite, comme illustré sur la figure 10, on fait tourner ou pivoter, selon l'axe du coffret 1, l'organe rotatif d'assemblage 9 par rapport à l'embase 3 et par rapport au socle 15 dans le sens contraire des aiguilles d'une montre jusqu'à ce que l'extrémité 33a de la languette 33 vienne en butée contre la nervure de butée 25. Après cette seconde rotation, l'organe rotatif d'assemblage 9 et le socle 15 sont alors, l'un par rapport à l'autre, dans une position finale d'assemblage.

Les moyens de guidage en rotation et d'accrochage 19 comprennent en outre des pluralités d'ergots allongés annulaires d'accrochage 46 et 47 qui sont aménagés respectivement sur les couronnes 11 et 18 de l'organe rotatif d'assemblage 9 et du socle 15 qui assurent le montage et le maintien entre eux du socle 15 et de l'organe rotatif d'assemblage 9. Les ergots allongés annulaires d'accrochage 46, qui sont espacés circonférentiellement, et les ergots allongés annulaires d'accrochage 47, qui sont également espacés circonférentiellement, peuvent être agencés pour indexer l'organe rotatif d'assemblage 9 par rapport au socle 15 lorsqu'ils sont mis l'un sur l'autre.

Lors de ladite seconde rotation, le plot 35 de l'organe d'assemblage 9 quitte le bossage 22a de la languette 22 de l'embase 3 et libère le commutateur 27. La carte électronique 22 est alors en marche.

D'un point de vue pratique, un utilisateur fixe le socle 15 sur une surface de réception par exemple d'un mur ou d'un plafond, puis installe sur le socle 15 le boîtier 2 équipé de l'organe rotatif d'assemblage 9 dans la position intermédiaire de montage comme décrit ci-dessus.

Si un utilisateur souhaite séparer l'organe rotatif d'assemblage 9 de l'embase 3, en l'absence du socle 15, il lui suffit d'appuyer sur la bosse 30a de la languette 30 pour la déformer vers l'avant de façon à libérer les ailes 31 et 32 par rapport aux plots de butée 28 et 29, de tourner l'organe rotatif d'assemblage 9 par rapport à l'embase 3 vers la position initiale de montage, de déformer vers l'arrière la languette 33 de façon à libérer son extrémité 33a par rapport à la nervure de butée 25 et de poursuivre la rotation de l'organe rotatif d'assemblage 9 jusqu'à la position initiale de montage.

Selon une application particulière, le boitier 2 du coffret 1 peut être équipé d'un organe de détection 48 monté par exemple au-dessous sur la carte électronique 6 (figure 1).

L'organe de détection 48 peut être un détecteur de fumée, un détecteur de gaz dangereux, un détecteur de rayonnements dangereux, un détecteur de chaleur, de froid, d'humidité, d'eau (inondation) ou un détecteur de coupure de courant, un détecteur de séisme, ou un détecteur de présence. Le boîtier 2 pourrait être équipé de plusieurs organes de détection différents.

Selon l'exemple décrit, la position angulaire intermédiaire est située sur le chemin de l'organe rotatif d'assemblage 9 entre la position angulaire initiale de montage et la position angulaire intermédiaire. Néanmoins, selon une variante de réalisation, la position angulaire finale d'assemblage pourrait être atteinte en tournant l'organe rotatif d'assemblage 9 dans le même sens que celui l'ayant amené à sa position angulaire intermédiaire de montage. Les moyens d'indexation et d'immobilisation de l'organe rotatif d'assemblage 9 à la position angulaire intermédiaire de montage seraient alors inversés et les autres moyens seraient alors adaptés en conséquence.

Selon d'autres variantes de réalisation, les moyens d'indexation angulaire et d'arrêt décrits, permettant les positionnements de l'organe rotatif d'assemblage 9 par rapport à l'embase 3 du boîtier 2 et par rapport au socle 15, à la position initiale de montage, à la position intermédiaire de montage et à la position finale d'assemblage, pourraient être différents et placés différemment.

Selon une variante de réalisation, le boîtier 2 pourrait être muni d'un commutateur électrique actionné par l'organe rotatif d'assemblage 9 lorsque ce dernier se trouve à la position angulaire finale d'assemblage, pour par exemple mettre en marche la carte électronique 6. Selon une autre variante de réalisation, le bouton poussoir 27 pourrait être inexistant.

Selon une variante de réalisation, le commutateur électronique 27 pourrait ne pas être monté sur la carte électronique 6 mais, par exemple, porté directement par l'embase 3 du boîtier 2 et relié à la carte électronique 6 par des fils électriques ou des pattes de connexion électrique.

La présente invention ne se limite pas aux exemples ci-dessus décrits. Bien des variantes de réalisation sont possibles sans sortir du cadre de l'invention.

## Revendications

1. Coffret comprenant :
un boîtier (2) et un socle (15) pouvant être placés l'un au-dessus de l'autre et assemblés par l'intermédiaire d'un organe rotatif d'assemblage (9),
dans lequel le boîtier (2) est muni d'un commutateur électrique (27),
dans lequel le boîtier (2) et l'organe rotatif d'assemblage (9) sont munis de moyens de guidage en rotation et d'accrochage (12) pour être montés l'un sur l'autre dans une position angulaire initiale de montage et être tournés l'un par rapport à l'autre vers une position angulaire intermédiaire indexée de montage où un plot (35) de l'organe rotatif d'assemblage (9) actionne ledit commutateur électrique (27),
et dans lequel le socle (15) et l'organe rotatif d'assemblage (9) sont munis de moyens de guidage en rotation et d'accrochage (19) pour être montés l'un sur l'autre dans position angulaire intermédiaire indexée de montage et tournés l'un par rapport à l'autre vers une position angulaire finale indexée d'assemblage où le plot (35) de l'organe rotatif d'assemblage (9) libère le commutateur électrique (27).

2. Coffret selon la revendication 1, comprenant des moyens de butée (29, 30, 26, 36) pour maintenir dans les deux sens le boîtier (2) et l'organe rotatif d'assemblage (9) à la position angulaire intermédiaire indexée de montage, et dans lequel le socle (15) comprend un moyen de libération (39) pour libérer au moins partiellement les moyens de butée (29, 30) lorsqu'il est mis en place à ladite position angulaire intermédiaire indexée de montage et autoriser la rotation de l'organe rotatif d'assemblage (9) jusqu'à la position angulaire finale indexée d'assemblage.

3. Coffret selon l'une des revendications 1 et 2, dans lequel la position angulaire intermédiaire indexée est située sur le chemin de l'organe rotatif d'assemblage (9) entre la position angulaire initiale indexée de montage et la position angulaire intermédiaire indexée.

4. Coffret selon la revendication 3, comprenant :
des moyens de butée (23, 30) de l'organe rotatif d'assemblage (9) par rapport au boîtier (2) à la position angulaire initiale indexée de montage, dans le sens opposé à sa rotation vers la position angulaire intermédiaire,
des moyens de butée (29, 30, 26, 36) de l'organe rotatif d'assemblage par rapport au boîtier (2) à la position angulaire intermédiaire indexée de montage dans les deux sens, les moyens de butée dans le sens de la rotation de l'organe rotatif d'assemblage (9) depuis la position angulaire intermédiaire indexée vers la position angulaire finale indexée étant escamotables sous l'effet d'un organe de libération (39) du socle (15), et
et des moyens de butée (33, 25) de l'organe rotatif d'assemblage par rapport au boîtier (2) à la position angulaire finale indexée, dans le sens de sa rotation vers la position angulaire initiale indexée, ces moyens de butée étant escamotables.

5. Coffret selon la revendication 4, dans lequel les moyens de butée comprennent des languettes et des nervures de butée aménagées respectivement sur le boîtier (2) et l'organe rotatif d'assemblage.

6. Coffret selon l'une quelconque des revendications précédentes, dans lequel le boîtier (2) et le socle (15) sont placés et maintenus l'un au-dessus de l'autre dans une position angulaire déterminée par des moyens de butée réciproques (23, 24, 37, 38).

7. Coffret selon l'une quelconque des revendications précédentes, dans lequel l'organe rotatif d'assemblage (9) comprend un plateau (10) interposé entre le boîtier et le socle et une couronne périphérique (11).

8. Coffret selon l'une quelconque des revendications précédentes, dans lequel le boîtier est muni d'un commutateur électrique actionné lorsque l'organe rotatif d'assemblage est à la position angulaire finale indexée.

9. Coffret selon l'une quelconque des revendications précédentes, dans lequel les moyens de guidage en rotation et d'accrochage (12, 19) comprennent des moyens d'appui axial, des moyens d'appui radial et des ergots d'accrochage.

10. Coffret selon l'une quelconque des revendications précédentes, dans lequel le boîtier (2) contient une carte électronique (6) munie dudit commutateur électrique (27).

## Patentansprüche

1. Kasten, der Folgendes umfasst:
ein Gehäuse (2) und einen Sockel (15), die übereinander platziert werden können und mittels eines drehbaren Verbindungselements (9) verbunden werden können,
wobei das Gehäuse (2) mit einem elektrischen Umschalter (27) versehen ist,
wobei das Gehäuse (2) und das drehbare Verbindungselement (9) mit Mitteln zur Führung bei der Drehung und zum Verrasten (12) versehen sind, um aufeinander in einer anfänglichen Winkelposition zur Montage montiert zu werden, und um relativ zueinander in eine zur Montage indexierten intermediären Winkelposition gedreht zu werden, in welcher eine Kontaktstelle (35) des drehbaren Verbindungselements (9) den elektrischen Umschalter (27) betätigt,
und wobei der Sockel (15) und das drehbare Verbindungselement (9) mit Mitteln zur Führung bei der Drehung und zum Verrasten (19) versehen sind, um in der zur Montage indexierten intermediären Winkelposition aufeinander montiert zu werden, und um im Verhältnis zueinander in eine zur Verbindung indexierten endgültigen Winkelposition gedreht zu werden, in welcher die Kontaktstelle (35) des drehbaren Verbindungselements (9) den elektrischen Umschalter (27) freigibt.

2. Kasten nach Anspruch 1,
der Anschlagsmittel (29, 30, 26, 36) umfasst, um das Gehäuse (2) und das drehbare Verbindungselement (9) in den beiden Richtungen in der zur Montage indexierten intermediären Winkelposition zu halten, und wobei der Sockel (15) ein Freigabemittel (39) umfasst, um die Anschlagmittel (29, 30) mindestens teilweise freizugeben, wenn er in der zur Montage indexierten intermediären Winkelposition angeordnet ist, und um die Drehung des drehbaren Verbindungselements (9) bis in die zur Verbindung indexierten endgültigen Winkelposition zu erlauben.

3. Kasten nach einem der Ansprüche 1 und 2,
wobei die indexierte intermediäre Winkelposition auf dem Weg des drehbaren Verbindungselements (9) zwischen der zur Montage indexierten anfänglichen Winkelposition und der indexierten intermediären Winkelposition liegt.

4. Kasten nach Anspruch 3,
der Folgendes umfasst:
Anschlagsmittel (23, 30) des drehbaren Verbindungselements (9) relativ zu dem Gehäuse (2) in der zur Montage indexierten anfänglichen Winkelposition, in die Richtung entgegengesetzt zu seiner Drehung in die intermediäre Winkelposition,
Anschlagsmittel (29, 30, 26, 36) des drehbaren Verbindungselements relativ zu dem Gehäuse (2) in der zur Montage indexierten intermediären Winkelposition in die beiden Richtungen, wobei die Anschlagsmittel in der Richtung der Drehung des drehbaren Verbindungselements (9) aus der indexierten intermediären Winkelposition in die indexierte endgültige Winkelposition unter der Wirkung eines Freigabeelements (39) des Sockels (15) einziehbar sind, und
Anschlagsmittel (33, 25) des drehbaren Verbindungselements relativ zu dem Gehäuse (2) in der indexierten endgültigen Winkelposition, in die Richtung seiner Drehung zu der indexierten anfänglichen Winkelposition, wobei diese Anschlagsmittel einziehbar sind.

5. Kasten nach Anspruch 4,
wobei die Anschlagsmittel Laschen und Anschlagsrippen umfassen, die jeweils an dem Gehäuse (2) und dem drehbaren Verbindungselement ausgebildet sind.

6. Kasten nach irgendeinem der vorhergehenden Ansprüche,
wobei das Gehäuse (2) und der Sockel (15) übereinander in einer Winkelposition, die durch die gegenseitigen Anschlagsmittel (23, 24, 37, 38) bestimmt wird, platziert sind und darin gehalten werden.

7. Kasten nach irgendeinem der vorhergehenden Ansprüche,
wobei das drehbare Verbindungselement (9) eine Platte (10), die zwischen das Gehäuse und den Sockel zwischengeschoben ist, und einen umfänglichen Kranz (11) umfasst.

8. Kasten nach irgendeinem der vorhergehenden Ansprüche,
wobei das Gehäuse mit einem elektrischen Umschalter versehen ist, der betätigt wird, wenn sich das drehbare Verbindungselement in der indexierten endgültigen Winkelposition befindet.

9. Kasten nach irgendeinem der vorhergehenden Ansprüche,
wobei die Mittel zur Führung bei der Drehung und zur Verrastung (12, 19) axiale Auflagemittel, radiale Auflagemittel und Rastvorsprünge umfassen.

10. Kasten nach irgendeinem der vorhergehenden Ansprüche,
wobei das Gehäuse (2) eine elektronische Leiterplatte (6) enthält, die mit dem elektrischen Umschalter (27) versehen ist.

## Claims

1. Kit comprising:
a housing (2) and a base (15) which can be placed above one another and assembled by means of a rotary assembly member (9),
wherein the housing (2) is equipped with an electric switch (27),
wherein the housing (2) and rotary assembly member (9) are provided with rotary guiding and attachment means (12) to be mounted on top of one another in an initial angular mounting position and to be turned towards one another to an intermediate indexed angular position, where a pin (35) of the rotary assembly member (9) activates said electric switch (27),
and wherein the base (15) and rotary assembly member (9) are equipped with rotary guiding and attachment means (19) to be mounted on top of one another in the intermediated indexed angular position and turned relative to one another towards a final indexed angular position of assembly where the pin (35) of the rotary assembly member (9) releases the electric switch (27).

2. Kit according to claim 1, comprising stop means (29, 30, 26, 36) for holding in both directions the housing (2) and rotary assembly member (9) in the intermediate indexed angular position of assembly and wherein the base (15) comprises a releasing means (39) for at least partly releasing the stop means (29, 30) when it is installed in said intermediate indexed angular position of assembly and authorising the rotation of the rotary assembly member (9) up to the final indexed angular position of the assembly.

3. Kit according to any one of claims 1 and 2, wherein the intermediate indexed angular position is located on the path of the rotary assembly member (9) between the initial indexed angular position of assembly and the intermediate indexed angular position.

4. Kit according to claim 3, comprising:
stop means (23, 30) of the rotary assembly member (9) relative to the housing (2) in the initial indexed angular position of assembly in the direction opposite its rotation towards the intermediate angular position,
stop means (29, 30, 26, 36) of the rotary assembly member relative to the housing (2) in the intermediate indexed angular position of assembly in both directions, the stop means in the direction of rotation of the rotary assembly member (9) from the intermediate indexed angular position towards the final indexed angular position being retractable under the effect of a releasing element (39) of the base (15), and
stop means (33, 25) of the rotary assembly member relative to the housing (2) in the final indexed angular position, in the direction of its rotation towards the initial indexed angular position, said stop means being retractable.

5. Kit according to claim 4, wherein the stop means comprise tabs and stop ribs arranged respectively on the housing (2) and rotary assembly member.

6. Kit according to any one of the preceding claims, wherein the housing (2) and the base (15) are positioned and held above one another in an angular position determined by the reciprocal stop means (23, 24, 37, 38).

7. Kit according to any one of the preceding claims, wherein the rotary assembly member (9) comprises a plate (10) interposed between the housing and the base and a peripheral crown (11).

8. Kit according to any one of the preceding claims, wherein the housing is provided with an electric switch which is activated when the rotary assembly member is in the final indexed angular position.

9. Kit according to any one of the preceding claims, wherein the rotary guiding and attachment means (12, 19) comprise axial bearing means, radial bearing means and fastening lugs.

10. Kit according to any one of the preceding claims, wherein the housing (2) contains an electronic card (6) provided with said electric switch (27).
